# EUROPEAN PATENT APPLICATION

(11) **EP 3 709 033 A1**
(43) Date of publication of application: **16.09.2020**
(21) Application number: 19162975.7
(22) Date of filing: 14.03.2019
(51) Int. Cl.: G01R 29/08

(54) **PERFORMANCE TEST SYSTEM FOR TESTING A COMPLEX SYSTEM UNDER TEST**

(71) Applicant: Rohde & Schwarz GmbH & Co. KG, 81671 München (DE)
(72) Inventor: NASEEF, Mahmud, 81671 München (DE); REIMER, Christian, 81671 München (DE)
(74) Representative: Prinz & Partner mbB

(57) **Abstract**

A performance test system for testing a complex system under test (12) has a communication tester (48) for testing wireless communication standards at the system under test (12), a user experience tester (50) for testing audio functionality, video functionality and/or user experience of the system under test (12), a signal generator (52) for generating an interference signal and/or a navigation signal, a radio frequency switch unit (54) for routing signals generated by the communication tester (48) and the user experience tester (50) and/or the signal generator (52), a spectrum analyzer (56) for spurious emissions monitoring and/or spectrum monitoring, and a control unit (26) connected to the communication tester (48), the user experience tester (50), the signal generator (52), the radio frequency switch unit (54) and the spectrum analyzer (56).

## Description

The invention is directed to a performance test system for testing a complex system under test.

Complex systems under test, for example vehicles, comprise several electronic components that may interfere with each other and the environment. Further, the electronic components may have one or more radio communication devices.

In total, a series of tests has to be performed on the system under test to assess the user experience, the functionality, the conformance and risks.

However, as the complex systems under test are usually large, large anechoic chambers are needed. However, large anechoic chambers are a valuable resource so that performing these tests is costly.

Thus, it is the purpose of the invention to provide a performance test system that allows to conduct several tests simultaneously.

For this purpose, a performance test system for testing a complex system under test is provided. The performance test system has a communication tester for testing wireless communication standards at the system under test, a user experience tester for testing audio functionality, video functionality and/or user experience of the system under test, a signal generator for generating an interference signal and/or a navigation signal, a radio frequency (RF) switch unit for routing signals generated by the communication tester and the user experience tester and/or the signal generator, a spectrum analyzer for spurious emissions monitoring and/or spectrum monitoring, and a control unit connected to the communication tester, the user experience tester, the signal generator, the radio frequency switch unit and the spectrum analyzer.

By providing a communication tester, a user experience tester, a signal generator and a spectrum analyzer, various tests, like user experience testing, over the air proximity coexistence tests, and spurious emissions tests may be performed simultaneously with the same test system. Further, the radio frequency switch unit assures that the signals do not interfere with each other in the test system to avoid distorted test results.

For a precise assessment, the user experience tester may comprise a video tester for testing video functionality and/or user experience of the system under test and/or the user experience tester may comprise an audio tester for testing audio functionality and/or user experience of the system under test.

The video tester may be a Rohde & Schwarz BTC and/or the audio tester may be a Rohde & Schwarz UPV.

In an embodiment, the performance test system comprises at least two transmit amplifiers (Tx-amplifiers), in particular exactly two transmit amplifiers, connected to the radio frequency switch unit. This way, it can be ensured that interference does not occur in the test system itself.

The transmit amplifier may be high power amplifiers.

In order to strictly prevent undesired interference, the radio frequency switch unit may be connected on one hand at least to the communication tester, the user experience tester and the signal generator and on the other hand to the at least two transmit amplifiers separately, and wherein the radio frequency switch unit may be configured to route signals generated by the communication tester, the user experience tester and the signal generator to one of the at least two transmit amplifiers according to a predefined routing scheme.

The radio frequency switch unit may be connected to an output port of the respective test component.

For example, the radio frequency switch unit is configured to route wanted signals generated by the communication tester, the user experience tester and/or the signal generator and unwanted signals generated by the signal generator to different ones of the at least two transmit amplifiers. Thus, the wanted signals are not disturbed by the unwanted signals.

In an aspect of the invention, the performance test system comprises a combiner connected to the at least two transmit amplifiers and adapted to combine output signals of the at least two transmit amplifiers. Thus, the signals may easily be combined again.

For a reliable measurement, the performance test system may comprise at least one receive amplifier, in particular exactly one receive amplifier. The receive amplifier may be a low noise amplifier.

For example, the communication tester, the user experience tester and/or the spectrum analyzer are connected to the receive amplifier, in particular via a tunable band pass filter bank. Thus, only one receive amplifier is needed.

The receive amplifier may be connected to an input port of the respective test component.

In order to reduce complexity of the performance test system, the performance test system may comprise at least one, in particular exactly one antenna system having a least one antenna, in particular exactly one antenna, particularly wherein the antenna system may be connected to the at least two transmit amplifiers, the combiner and/or the at least one receive amplifier.

For example, the antenna system in total is a broadband system and/or the at least one antenna is a broadband antenna.

In a variant of the invention, the performance test system comprises a network analyzer for calibrating the performance test system, allowing to increase the measurement accuracy further.

For precise power measurements, the performance test system may comprise a power meter, particularly a frequency selective power meter.

In an embodiment of the invention, the communication tester, the user experience tester, the signal generator, the radio frequency switch unit, the spectrum analyzer, the control unit, the at least two transmit amplifiers, the combiner, the at least one receive amplifier and/or the network analyzer are integrated in a housing or at least one, particularly exactly one or exactly two racks. This way, a compact system is obtained.

For example, the communication tester, the user experience tester, the signal generator, the radio frequency switch unit and the spectrum analyzer are integrated in a first rack, particularly wherein the at least two transmit amplifiers and the at least one receive amplifier are integrated in a second rack. The second rack may be separate from the first rack. This way, a clear distinction between the instrument stage and the amplification stage is provided.

In order conduct complete measurements on large systems under test, the performance test system may comprise a rotation mechanism, in particular a turntable.

In an aspect, the control unit comprises desktop computer, a laptop computer, a tablet computer and/or a virtual reality platform allowing a versatile mode of controlling the performance measurement system.

For example, the connection between the control unit and the test components is established via a cable, for example via LAN, or wirelessly, for example via Wifi.

Further features and advantages will be apparent from the following description as well as the accompanying drawings, to which reference is made. In the drawings:
- Figure 1 shows schematically a performance test system according to the invention, and
- Figure 2 shows a block diagram of the performance test system.

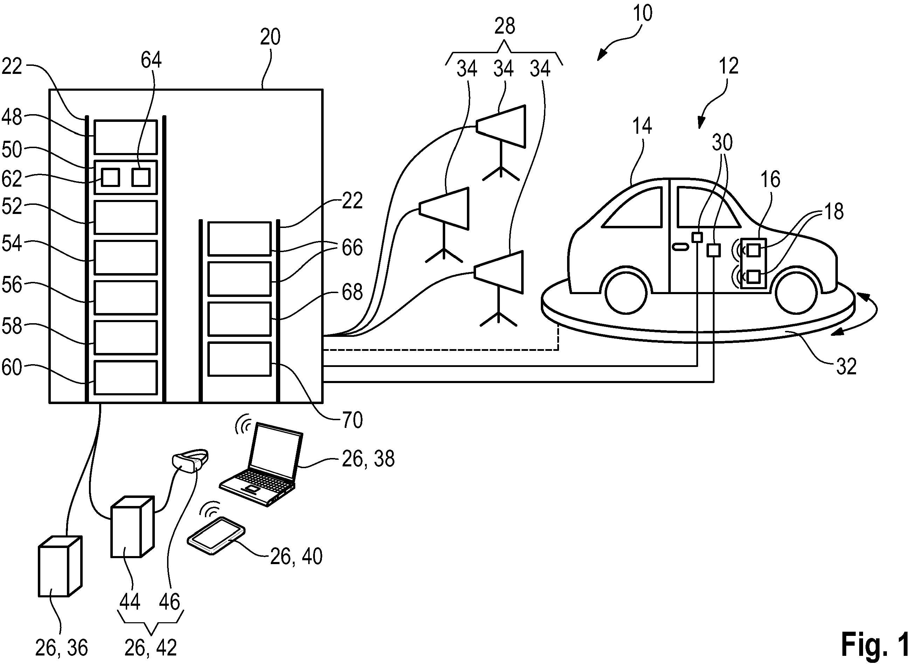

Figure 1 shows schematically a performance test system 10 and a system under test 12 (SUT), which is a vehicle 14 in the shown embodiment.

The system under test 12 comprises one or more electronic components 16, like an entertainment system with a screen, a telephone system, a navigation system, or the like. The electronic components 16 may each or jointly comprise at least one radio communication device 18. In the shown embodiment, two radio communication devices are shown.

Even though the system under test 12 is shown as a vehicle 14 in the embodiment, the system under test 12 may be any other large system with radio communication devices, e.g. household devices, like a refrigerator or a washing machine, a drone, or one or more wearables.

The performance test system 10 is configured for carrying out various tests on the electronic component 16 of the system under test 12 simultaneously. The tests may be functionality tests of the electronic component 16, conformance tests risk assessment tests, user experience tests and/or over the air proximity coexistence tests. Of course, various other tests may be performed using the performance test system 10.

The performance test system 10 comprises a housing 20 with two racks 22 holding test components 24 of the performance test system 10, one or more control units 26, an antenna system 28, at least one external component 30 and a rotation mechanism 32.

The rotation mechanism 32 may be a turntable on which the system under test 12 is placed and may be rotated. The rotation mechanism is controlled by the control unit 26.

The housing 20 includes a first rack 22 and a second rack 22, separate from the first rack 22.

The external components 30, two in the shown embodiment, are located inside the system under test 12, e.g. in the passenger cabin of the vehicle 14.

One of the external components 30 is a power meter having an antenna for measuring spurious emissions in the system under test 12.

The other external component 30 is a probe having a microphone and/or a camera to visually or aurally inspect the performance of one or more of the electronic components 16.

The external components 30 are connected to the test components 24 and/or the control unit 26 with a cable or wirelessly.

The antenna system 28 comprises at least one antenna 34, in the shown embodiment three antennas. For example, the antennas 34 are horn antennas, Vivaldi probe antennas and/or beamforming antennas, like an RRH (remote radio head) cluster. The antennas 34 are directed to the system under test 12.

The antenna system 28 is a broadband system and/or the antennas 34 are broadband antennas.

The control unit 26 may be a desktop computer 36, a laptop computer 38, a tablet computer 40 or a virtual reality platform 42.

The virtual reality platform 42 comprises a processing device 44 and virtual reality glasses 46 connected thereto.

The control unit 26 may be located outside of the housing 20.

The control unit 26 may be connected to the test components 24 via a cable, for example using a local area network. In the shown embodiment, the desktop computer 36 and the processing device 44 of the virtual reality platform 42 are connected to the test components 24 via a cable.

In addition or in the alternative, the control unit 26 may be connected to the test components 24 using a wireless connection, like a Wi-Fi connection. For example, the laptop computer 38 and the tablet computer 40 are connected to the test components 24 via a wireless connection.

The test components 24 in the first rack 22 are a communication tester 48, a user experience tester 50, a signal generator 52, a radio frequency (RF) switch unit 54, a spectrum analyzer 56, a network analyzer 58 and a power meter 60, for example a frequency selective power meter.

The communication tester 48 is configured for testing the wireless communication standards of the radio communication devices 18 of the system under test 12. The communication tester 48 may be a Rhode & Schwarz CMW communication tester.

The user experience tester 50 comprises a video tester 62 and an audio tester 64.

The video tester 62 is configured for testing the video functionality and/or the user experience of the electronic components 16 of the system under test 12. For example, the video tester 62 is a Rhode & Schwarz BTC.

The audio tester 64 is configured for testing the audio functionality and the user experience of the electronic components 16 of the system under test 12. The audio tester 64 may be a Rhode & Schwarz UPV.

For example, the user experience tester 50 may test the functionality and the user experience of an entertainment system of the vehicle 14 and of a telephone system of the vehicle 14.

The signal generator 52 is configured to generate an interference signal and/or a navigation signal, i.e. a signal resembling the signal of a global navigation satellite system (GNSS).

The spectrum analyzer 56 is configured for monitoring spurious emissions received by the antenna system 28 and monitoring the spectrum of the received signals.

The radio frequency switch unit 54 is connected to the outputs of the communication tester 48, the user experience tester 50 and the signal generator 52. The radio frequency switch unit 54 is configured for routing the signals of these test components 24 according to a predefined routing scheme.

The radio frequency switch unit 54 may be a Rhode & Schwarz OSP.

The network analyzer 58 is configured for calibrating the performance test system 10.

The control unit 26 is connected to these test components 24 of the first rack 22, namely the communication tester 48, the user experience tester 50, the signal generator 52, the radio frequency switch unit 54, the spectrum analyzer 56, the network analyzer 58 and/or the power meter 60.

The first rack can be regarded as the instrumentation stage of the performance test system 10. The second rack holds the test components 24 that may be regarded as an amplification stage of the performance test system 10.

The second rack 22 holds at least test components 24 being at least two transmit amplifiers 66 (Tx-amplifiers), at least one receive amplifier 68 (Rx-amplifier) and a combiner 70.

In the shown embodiment, exactly two transmit amplifiers 66 and exactly one receive amplifier 68 are provided.

The transmit amplifiers 66 may be high power amplifiers (HPA) and/or the receive amplifier 68 may be a low noise amplifier (LNA).

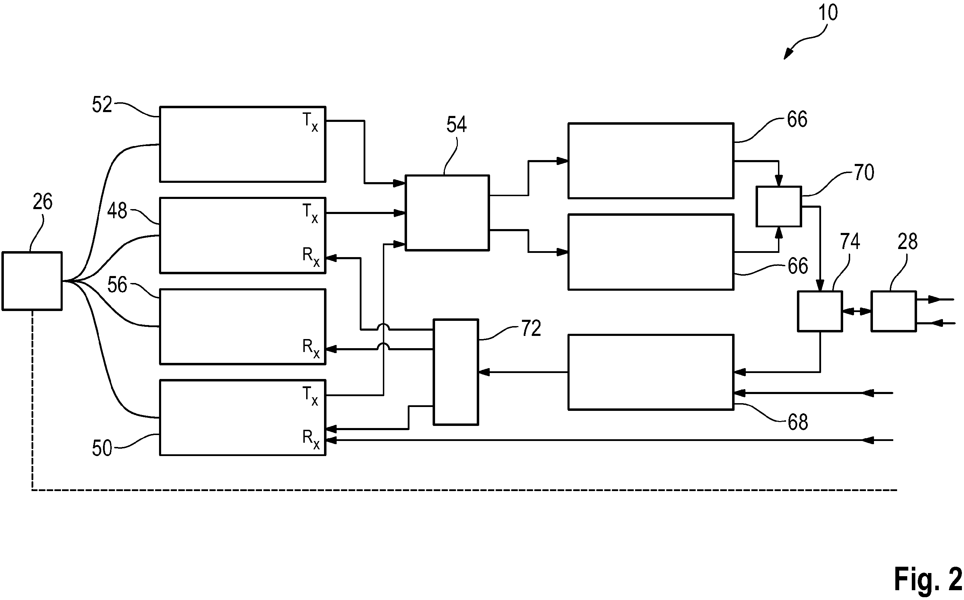

The precise connections of the test components 24 is shown in more detail in the schematic block diagram of Figure 2.

Apart from the components described with respect to Figure 1, in Figure 2 a tunable band pass filter (BPF) bank 72 and a circulator 74 of the performance test system 10 are shown. These components have not been shown in Figure 1 for simplicity.

The tunable BPF bank 72 and the circulator 74 may be arranged on the first rack 22 or the second rack 22.

The tunable BPF bank 72 is connected to the input ports of the communication tester 48, the spectrum analyzer 56 and the user experience tester 50.

Further, the user experience tester 50 may receive on its input port signals from the external components 30, like the probe.

As explained with respect to Figure 1, the control unit 26 is connected to at least the signal generator 52, the communication tester 48, the spectrum analyzer 56 and the user experience tester 50 in order to control all or part of these test components 24.

On the downlink or Tx-path (transmit path) of the performance test system 10, the output port of the signal generator 52, the output port of the communication tester 48 and the output port of the user experience tester 50 are connected to the input of the radio frequency switch unit 54.

The transmit amplifiers 66 are connected to the outputs of the radio frequency switch unit 54, wherein each of the transmit amplifiers 66 is connected to a different output port of the radio frequency switch unit 54. In other words, the transmit amplifiers 66 are separately connected to the radio frequency switch unit 54.

The outputs of the transmit amplifiers 66 are connected to the inputs of the combiner 70, whose output is in turn connected to the circulator 74.

The circulator 74 is connected to the antenna system 28.

On the uplink or Rx-path (receive path) of the performance test system, the antenna system 28 is connected to the circulator 74, which is also connected to an input of the receive amplifier 68. Thus, the Tx-path and the Rx-path share the circulator 74 and the antenna system 28.

The input of the receive amplifier 68 may also be connected to the external components 30, for example a power meter located inside the system under test 12.

The output of the receive amplifier 68 is connected to the tunable BPF bank 72 that distributes the signals.

For this purpose, the tunable BPF bank 72 is connected to the input ports of the communication tester 48, the spectrum analyzer 56 and the user experience tester 50.

For conducting performance tests on the system under test 12, in an exemplary embodiment, the communication tester 48 generates a communication signal, for example a signal according to a cellular standard (LTE, 5G) and the user experience tester 50 generates a video signal, for example DVB-T signal.

The signals of the communication tester 48 and of the user experience tester 50 are considered as "wanted signals" because these signals convey information to the system under test 12.

On the contrary, the signal generator 52 is generating an interference signal. The interference signal does not convey information to the system under test 12 and may thus be regarded as an "unwanted" signal.

In another test scenario, the signal generator 52 may generate a navigation signal resembling a GNSS signal. This signal would be considered a wanted signal.

In the shown embodiment, the communication signal of the communication tester 48, the audio/video signal of the user experience tester 50 and the interference signal of the signal generator 52 are transmitted to the radio frequency switch unit 54.

The radio frequency switch unit 54 is configured to route the signals received from the signal generator 52, the communication tester 48 and the user experience tester 50 to one or both of the transmit amplifiers 66 according to a predefined routing scheme.

In the exemplary embodiment, the predefined routing scheme defines that the wanted signals should be routed to one of the transmit amplifiers 66 and the unwanted signals shall be routed to the other one of the transmit amplifiers 66.

Thus, the radio frequency switch unit 54 routes the communication signal and the video signal to one of the transmit amplifiers 66 and the interference signal of the signal generator 52 to the other one of the transmit amplifiers 66.

The signals are then amplified accordingly and fed to the combiner 70 which is adapted to combine the output signals of transmit amplifiers 66.

The combined output signal is then transmitted to the circulator and in turn fed to the antenna system 28.

The combined signal is then emitted towards the system under test 12.

The signals received from the system under test 12 by the antenna system 28 or the external components 30 are fed to and amplified by the receive amplifier 68.

Then, the tunable BPF bank 72 splits the received signal in signal parts based on the frequency and distributes the parts of different frequencies to the input port of the communication tester 48, the spectrum analyzer 56 and the user experience tester 50 accordingly.

It is of course possible, that the spectrum analyzer 56 receives the entire received signal.

Based on the received signal, the communication tester 48 may evaluate the quality of the wireless communication and thus the wireless communication standard with the system under test 12, more precisely the radio communication device 18.

Likewise, the user experience tester 50 may assess the audio functionality, the video functionality and the user experience of the electronic components 16 of the system under test 12 based on the received signals.

Further, the spectrum analyzer 56 may assess the spurious emissions and the spectrum emitted from the system under test 12.

For the sake of simplicity, Figure 2 does not show the power meter 60, which may also receive portions or the whole received signal and may be used to assess, for example, the spurious emissions.

Thus, using the performance test system 10, functionality tests, conformance risk assessment tests, and user experience tests may be performed simultaneously using a single system. Thus, testing time is reduced drastically.

## Claims

1. Performance test system for testing a complex system under test (12), having:
a communication tester (48) for testing wireless communication standards at the system under test (12),
a user experience tester (50) for testing audio functionality, video functionality and/or user experience of the system under test (12),
a signal generator (52) for generating an interference signal and/or a navigation signal,
a radio frequency switch unit (54) for routing signals generated by the communication tester (48) and the user experience tester (50) and/or the signal generator (52),
a spectrum analyzer (56) for spurious emissions monitoring and/or spectrum monitoring, and
a control unit (26) connected to the communication tester (48), the user experience tester (50), the signal generator (52), the radio frequency switch unit (54) and the spectrum analyzer (56).

2. Performance test system according to claim 1, **characterized in that** the user experience tester (50) comprises a video tester (62) for testing video functionality and/or user experience of the system under test (12) and/or wherein the user experience tester (50) comprises an audio tester (64) for testing audio functionality and/or user experience of the system under test (12).

3. Performance test system according to claim 1 or 2, **characterized in that** the performance test system (10) comprises at least two transmit amplifiers (66), in particular exactly two transmit amplifiers (66), connected to the radio frequency switch unit (54).

4. Performance test system according to claim 3, **characterized in that** the radio frequency switch unit (54) is connected on one hand at least to the communication tester (48), the user experience tester (50) and the signal generator (52) and on the other hand to the at least two transmit amplifiers (66) separately, and wherein the radio frequency switch unit (54) is configured to route signals generated by the communication tester (48), the user experience tester (50) and the signal generator (52) to one of the at least two transmit amplifiers (66) according to a predefined routing scheme.

5. Performance test system according to claim 4, **characterized in that** the radio frequency switch unit (54) is configured to route wanted signals generated by the communication tester (48), the user experience tester (50) and/or the signal generator (52) and unwanted signals generated by the signal generator (52) to different ones of the at least two transmit amplifiers (66).

6. Performance test system according to any one of the claims 3 to 5, **characterized in that** the performance test system (10) comprises a combiner (70) connected to the at least two transmit amplifiers (66) and adapted to combine output signals of the at least two transmit amplifiers (66).

7. Performance test system according to any one of the preceding claims, **characterized in that** the performance test system (10) comprises at least one receive amplifier (68), in particular exactly one receive amplifier (68).

8. Performance test system according to claim 7, **characterized in that** the communication tester (48), the user experience tester (50) and/or the spectrum analyzer (56) are connected to the receive amplifier (68), in particular via a tunable band pass filter bank (72).

9. Performance test system according to any one of the preceding claims, **characterized in that** the performance test system (10) comprises at least one, in particular exactly one antenna system (28) having a least one antenna (34), in particular exactly one antenna (34), particularly wherein the antenna system (28) is connected to the at least two transmit amplifiers (66), the combiner (70) and/or the at least one receive amplifier (68).

10. Performance test system according to any one of the preceding claims, **characterized in that** the performance test system (10) comprises a network analyzer (58) for calibrating the performance test system (10).

11. Performance test system according to any one of the preceding claims, **characterized in that** the performance test system (10) comprises a power meter (60), particularly a frequency selective power meter.

12. Performance test system according to any one of the preceding claims, **characterized in that** the communication tester (48), the user experience tester (50), the signal generator (52), the radio frequency switch unit (54), the spectrum analyzer (56), the control unit (26), the at least two transmit amplifiers (66), the combiner (70), the at least one receive amplifier (68) and/or the network analyzer (58) are integrated in a housing (20) or at least one, particularly exactly one or exactly two racks (22).

13. Performance test system according to claim 12, **characterized in that** the communication tester (48), the user experience tester (50), the signal generator (52), the radio frequency switch unit (54) and the spectrum analyzer (56) are integrated in a first rack (22), particularly wherein the at least two transmit amplifiers (66) and the at least one receive amplifier (68) are integrated in a second rack (22).

14. Performance test system according to any one of the preceding claims, **characterized in that** the performance test system (10) comprises a rotation mechanism (32), in particular a turntable.

15. Performance test system according to any one of the preceding claims, **characterized in that** the control unit (26) comprises desktop computer (36), a laptop computer (38), a tablet computer (40) and/or a virtual reality platform (42).
